Europäisches Patentamt

European Patent Office

Office européen des brevets

(19)

(11) Numéro de publication : **0 051 504**
**B1**

(12) **FASCICULE DE BREVET EUROPÉEN**

(45) Date de publication du fascicule du brevet :
28.12.83

(51) Int. Cl.³ : **H 01 L 29/10**, H 01 L 29/80, H 01 L 29/36

(21) Numéro de dépôt : **81401504.6**

(22) Date de dépôt : **29.09.81**

(54) Transistors à effet de champ à grille ultracourte.

(30) Priorité : **31.10.80 FR 8023385**

(43) Date de publication de la demande :
**12.05.82 Bulletin 82/19**

(45) Mention de la délivrance du brevet :
**28.12.83 Bulletin 83/52**

(84) Etats contractants désignés :
**DE GB IT NL**

(56) Documents cités :
**US-A- 3 999 281**
**EXTENDED ABSTRACTS OF THE JOURNAL OF THE ELECTROCHEMICAL SOCIETY, vol. 80-2, octobre 1980 Princeton, US L.F. EASTMAN et al.: "Ballistic electron motion in GaAs for logic devices with subpicosecond transit time", pages 1216-1217**
**IEEE ELECTRON DEVICE LETTERS, vol. EDL-1, no. 10, octobre 1980 New York, US J.R. BARKER et al.: "On the Nature of Ballistic Transport in Short Channel Semiconductor Devices", pages 209-210**

(73) Titulaire : **THOMSON-CSF**
**173, Boulevard Haussmann**
**F-75379 Paris Cedex 08 (FR)**

(72) Inventeur : **Etienne, Patrick**
**THOMSON-CSF SCPI - 173, bld Haussmann**
**F-75360 Paris Cedex 08 (FR)**
Inventeur : **Nuyen, Trong Linh**
**THOMSON-CSF SCPI - 173, bld Haussmann**
**F-75360 Paris Cedex 08 (FR)**

(74) Mandataire : **Taboureau, James et al**
**THOMSON-CSF SCPI 173, Bld Haussmann**
**F-75379 Paris Cedex 08 (FR)**

Jouve, 18, rue St-Denis, 75001 Paris, France

## Transistors à effet de champ à grille ultracourte

La présente invention concerne les dispositifs à semi-conducteurs de type transistors à effet de champ, et plus spécialement ceux dont les grilles sont plus courtes que le libre parcours moyen des électrons dans le matériau semi-conducteur.

Les transistors à effet de champ connus fonctionnent soit selon une structure plane, le courant circulant dans le plan de la pastille de matériau semi-conducteur, soit selon une structure verticale, le courant circulant perpendiculairement à ce même plan.

Les transistors MESFET (de l'anglais Metal Schottky Field Effect Transistor), ayant une structure dite planar, possèdent sur la face libre de la plaquette les contacts ohmiques source et drain et le contact Schottky de grille. Les MESFET présentent de bonnes performances dans les domaines d'hyperfréquences ainsi que dans les circuits logiques. Cependant, afin d'améliorer leurs caractéristiques à très haute fréquence ou à très faible temps de commutation, il faut réduire la longueur de la grille jusqu'à des dimensions de 0,1 micron ou moins. Une telle réduction de la longueur de grille n'est pas aisée en technologie « planar », et est limitée par les techniques de masquage.

Le Gridistor (Brevet Français n° 1 137 256 du 16 décembre 1961 et ses additions) est un transistor à effet de champ à jonction, à structure verticale possédant un grand nombre de grilles en parallèle. C'est donc un dispositif développant beaucoup de puissance. Mais sa fréquence de fonctionnement est basse en raison des capacités parasites élevées et d'une forte résistance de grille. De plus, par sa structure, plus la longueur de grille est faible, plus cette résistance est forte.

C'est pour pallier les inconvénients rencontrés dans les transistors communs de type MESFET et Gridistor, notamment en fréquence de fonctionnement, que de nouvelles structures de transitor à effet de champ ayant de très courtes longueurs de grille et de faibles résistances de grille et d'accès de source et de drain ont été mises au point.

Les transistors à effet de champ selon l'invention fonctionnent selon une structure verticale, comparable à celle qui a été exposée au sujet du gridistor.

Cependant, la longueur de grille, dans les transistors selon l'invention est beaucoup plus faible que dans le Gridistor, parce que l'invention s'affranchit des grilles de type P incluses entre deux couches de type N par diffusion, soit une longueur de grille de l'ordre de la longueur de diffusion.

La longueur de grille, dans l'invention, est limitée à une épaisseur de couche épitaxiale, que l'on sait réaliser très mince, de l'ordre de quelques centaines d'angströms, et l'effet de grille, par pincement d'une zone dépeuplée en électrons, est obtenu par une métallisation, située dans le plan de la couche de grille mais latéralement, en contact électrique avec elle, et qui permet d'appliquer la tension de contrôle de grille.

De façon plus précise, l'invention concerne un transistor à effet de champ, à grille ultracourte, tel qu'énoncé dans la revendication 1.

L'invention sera mieux comprise par la description d'un exemple de réalisation, laquelle s'appuie sur des figures parmi lesquelles :

La figure 1 représente une coupe schématique d'un MESFET selon l'art connu ;

La figure 2 représente le diagramme de variation de la vitesse des électrons en fonction de la distance parcourue, dans un matériau semi-conducteur ;

La figure 3 représente une coupe schématique d'un Gridistor selon l'art connu ;

La figure 4 représente la répartition de la concentration en électrons dans une structure multicouche où la couche centrale faiblement dopée est intercalée entre deux couches fortement dopées ;

La figure 5 représente en coupe schématique, un exemple de transistor à grille ultracourte selon l'invention.

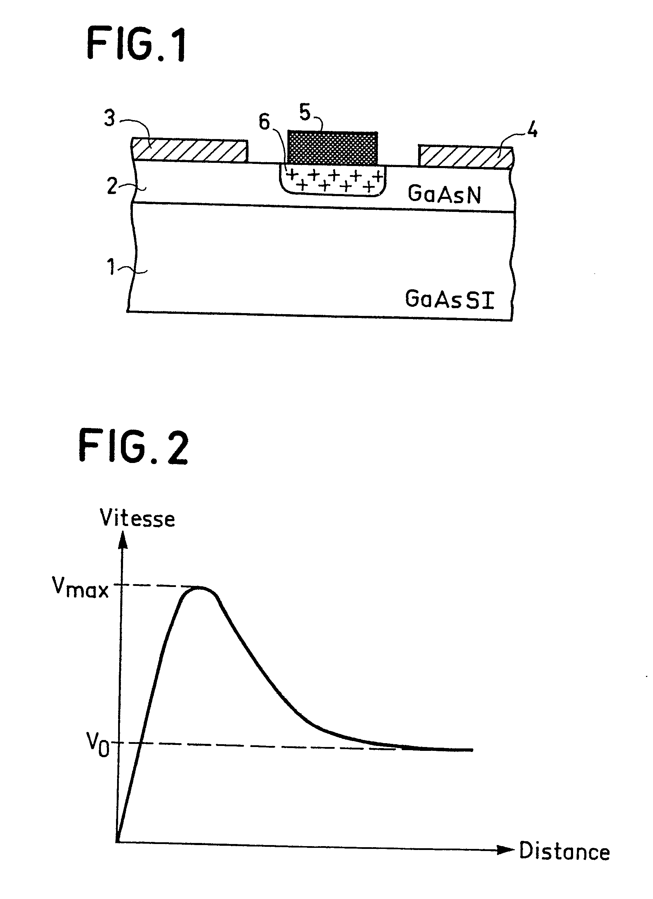

La figure 1 représente la coupe schématique d'un transistor MESFET selon l'art connu : de façon à se rapprocher du domaine de l'invention, celui des hyperfréquences, le matériau choisi pour cet exemple est parmi d'autres possibles, l'arséniure de gallium.

Sur un substrat 1 en GaAs semi-isolant est déposée une couche 2 en GaAs de type N. Les contacts ohmiques 3 de source et 4 de drain sont déposés par métallisation. Par l'intermédiaire de la grille 5, soumise à une tension de contrôle, se développe une région de charge d'espace 6 dont l'épaisseur dépend de la tension grille. Le courant source-drain est donc modulé par la tension grille. La strcture est dite planar.

La fréquence de fonctionnement ou le temps de commutation de ce type de transistor, dépend du temps de transit des électrons sous la grille. Or ce temps de transit est d'autant plus faible que la grille est plus courte. Il est donc avantageux de réduire la longueur de la grille. Cette réduction est d'autant plus intéressante que, pour de très courtes longueurs de grille (quelques centaines d'Å à quelques milliers d'Å selon le dopage du matériau) un phénomène physique, appelé transport balistique, doit être pris en compte.

Le transport balistique des électrons peut se décrire succintement comme suit : on peut définir pour un électron, en déplacement sous un champ électrique, un libre parcours moyen tenant compte des collisions de cet électron dans le réseau cristallin : collision avec les impuretés, avec les phonons, etc... Lorsque la distance parcourue par l'électron est plus faible que le libre parcours moyen, l'électron atteint une vitesse maximale, supérieure à celle qu'il possède après collisions, car à chaque collision il perd de l'énergie.

La figure 2 représente ce phénomène, dans

lequel $v_0$ est la vitesse en régime d'équilibre et $v_{max}$ est la vitesse maximale atteinte en régime balistique. Selon le champ électrique appliqué, la vitesse $v_{max}$ peut être de 3 à 10 fois la vitesse $v_0$. En d'autres termes, lorsque la longueur de grille est suffisamment faible pour que le transport balistique ait lieu, le temps de transit des électrons sous la grille est extrêmement court. Le transistor fonctionne alors à très haute fréquence de coupure ou, pour les circuits logiques, à de très faibles temps de commutation.

Il est donc utile de réduire la longueur de grille des MESFET jusqu'à des dimensions voisines de 0,1 micron, mais ceci nécessite une technologie assez lourde, et il est difficile d'envisager, des dimensions inférieures à 0,1 micron, au stade de l'art actuel de la technologie planar.

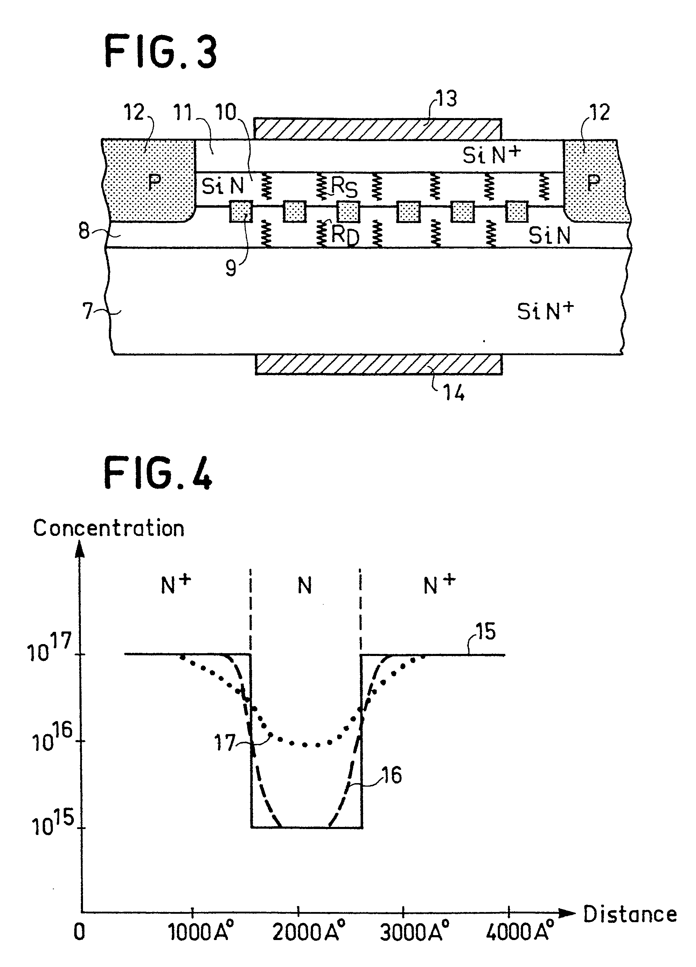

D'autre part on connaît le Gridistor dont la coupe schématique est représentée sur la figure 3.

Sur un subtrat 7 en silicium de type N$^+$, fortement dopé, est déposée une couche 8 en Si de type N. On implante ou diffuse alors dans la couche 8, des grilles 9 de type P. On dépose ensuite successivement les couches 10 de type N et 11 de type N$^+$. On implante ensuite les caissons 12 de type P, qui font le tour du transistor afin de relier les grilles 9 entre elles. Par l'intermédiaire des métallisations 13 et 14 on peut faire passer un courant entre source et drain. Ce courant est modulé par la tension grille. On peut remarquer que ce courant n'est pas dans le plan du substrat. Le Gridistor est dit de structure verticale par opposition avec la structure planar bien connue de l'homme de l'art.

Un autre transistor à effet de champ, à structure verticale, est décrit par le brevet US-A-3 999 281. Il s'agit d'un MESFET. Alors que dans le Gridistor, la grille est réalisée par un matériau semi-conducteur P enterré dans une couche N, ce qui complique la réalisation puisque des reprises d'épitaxie sont nécessaires, le MESFET décrit dans le brevet US-A-3 999 281 comporte une grille métallique déposée dans le fond de sillons creusés dans la couche N. Le contrôle du courant entre source et drain se fait par le champ électrique créé à l'intérieur des mailles de ce réseau métallique. Néanmoins, la couche N, dans laquelle la grille agit, est importante : elle va depuis le substrat (source ou drain) jusqu'à la métallisation (drain ou source) supportée par le mésa formé entre deux sillons. Ainsi, la longueur de grille est importante.

Par convention on définit la longueur de grille comme la distance parcourue par les électrons sous la grille. Dans le cas du Gridistor la longueur de grille est donc l'épaisseur de la zone 8 implantée ou diffusée. Par ailleurs la structure du Gridistor permet de mettre en parallèle plusieurs grilles, ce qui est favorable à la réalisation d'un dispositif de puissance. Mais plusieurs facteurs font qu'il est limité en fréquence de fonctionnement : la grille, de type P présente une grande résistance, les capacités parasites créées par les caissons 12 et les plots de soudure des grilles sont très élevées et enfin, la longueur de grille atteint difficilement quelques milliers d'Å ; ce qui est insuffisant pour bénéficier du phénomène de transport balistique. De plus, une réduction de la longueur de grille provoquerait une augmentation notable de sa résistance. Enfin, les couches 8 et 10 étant d'épaisseur supérieure à la longueur de grille, il s'y crée des résistances parasites d'accès $R_S$ et $R_D$ élevées.

Les transistors selon l'invention, ont une structure verticale comme le Gridistor mais présentent d'importants progrès en ce qui concerne les fréquences du fonctionnement, et une simplification de réalisation industrielle.

En premier lieu, l'épaisseur de la couche active est faible, de l'ordre de plusieurs centaines d'angströms, afin d'être le siège du transport balistique d'électrons.

En second lieu, la couche active est comprise entre deux couches fortement dopées, elles-mêmes de faible épaisseur, afin de minimiser les résistances d'accès $R_S$ et $R_D$.

En troisième lieu, la couche active est faiblement dopée, mais du fait que cette couche est très mince et qu'elle est comprise entre des couches fortement dopées, la concentration en électrons dans la couche active est élevée, plus élevée que la concentration en impuretés.

Cette propriété est décrite sur la figure 4 : la ligne 15 (en trait plein) représente les niveaux de dopage visés théoriquement dans la structure N$^+$NN$^+$, la ligne 16 (en traits tirés) représente le profil réel des impuretés compte tenu de la diffusion de ces impuretés entre couches, et la ligne 17 (en pointillé) représente le profil réel des électrons libres. La concentration en électrons libres dans la région N peu dopée est plus forte que celle des impuretés dopants : la région N gagne des électrons au dépend des régions N$^+$. Une structure N$^+$NN$^+$ présente par rapport à une structure où la couche active N est intentionnellement dopée à un niveau, par exemple, de $10^{17}$ at.cm$^{-3}$, non seulement l'avantage d'être le siège du transport balistique mais de faciliter la réalisation du transistor.

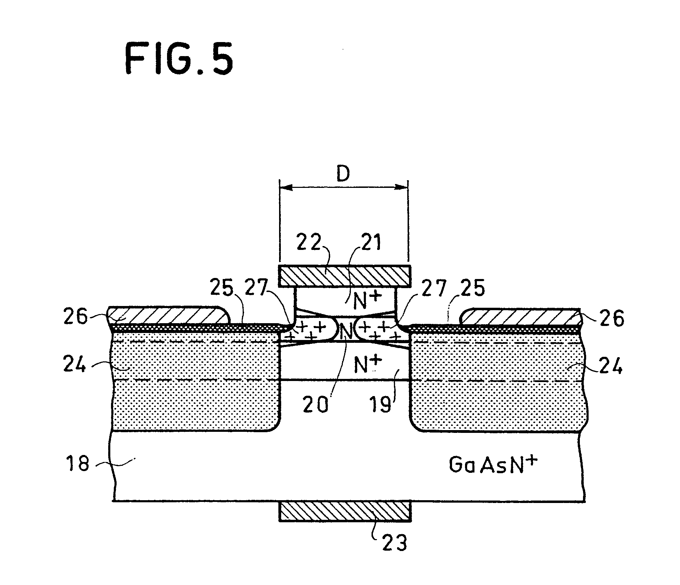

La figure 5 représente, en coupe schématique, un exemple de transistor selon l'invention.

Sur un substrat 18 en GaAs de type N$^+$ fortement dopé sont déposées successivement par épitaxie une première couche 19 de type N$^+$ dopée à quelques $10^{18}$ at.cm$^{-3}$ d'épaisseur de 1 000 à plusieurs milliers d'Å, une seconde couche 20 de type N de concentration en impuretés d'environ $10^{15}$ at.cm$^{-3}$ et d'épaisseur de plusieurs centaines d'Å, et une troisième couche 21 de type N$^+$ dopée à quelques $10^{18}$ at.cm$^{-3}$ d'épaisseur de 1 000 Å environ. Une métallisation 22 est déposée sur la couche 21 pour constituer un premier contact ohmique, source ou drain. Le second contact, 23 drain ou source, est déposé sur l'autre face du substrat 18.

Par opération de lithographie connue de l'homme de l'art, on définit sur le contact 22 un plot de dimensions latérales D équivalentes à environ deux fois la profondeur des zones dépeuplées d'électrons 27. Pour un dopage 10¹⁵ at.cm⁻³, la profondeur des zones dépeuplées 27 est de 1 micron environ. Une dimension de 2 microns est très facilement réalisable par les opérations de lithographie classique.

Par gravure ionique on enlève ensuite la couche 21 sauf dans les parties situées en dessous du contact 22. On attaque ensuite l'ensemble avec une solution chimique de telle façon que la couche 21 soit en retrait par rapport au contact 22, et que la couche 20 soit partiellement attaquée sur la moitié de son épaisseur environ. On peut choisir une orientation cristallographique telle que cette attaque chimique crée un plan incliné sur la couche 20. Les deux caissons 24 de haute résistivité sont obtenus par bombardement de particules chargées telles que par exemple les protons, la partie centrale étant protégée des protons par la métallisation 22. On dépose ensuite les deux métallisations 25 de grille par évaporation. Cette évaporation peut être inclinée par rapport à la normale au plan du substrat de façon à ce que les métallisations 25 recouvrent le flanc de la couche 20. L'épaisseur des métallisations doit être plus faible que celle de la couche 20. Afin de réduire la résistance de grille, on dépose une surépaisseur 26 de métallisation sur les grilles.

La modulation du courant source-drain est obtenue par polarisation des grilles 25, qui fait varier la profondeur des zones de charge d'espace 27. Du fait que les épaisseurs des couches 20 et 25 sont très faibles (quelques centaines d'Angströms) la distance parcourue par les électrons sous les grilles est très faible et le régime de transport balistique est obtenu. Ce régime est d'autant plus facile à atteindre que la concentration en impuretés dans la couche active 20 est faible. D'autre part, les capacités parasites sont fortement diminuées grâce aux caissons 24.

Afin de mieux contrôler les profils d'impuretés dans la structure N⁺NN⁺ on peut intercaler entre les couches 19 et 20 et les couches 20 et 21 une couche mince d'épaisseur de l'ordre de quelques centaines d'angströms et de dopage de l'ordre de 10¹⁷ at.cm⁻³.

Ce type de transistors plus particulièrement réalisé avec des matériaux du type GaAs et de la famille III-V, trouve ses applications dans le domaine des hyperfréquences, notamment pour les télécommunications.

## Revendications

1. Transistor à effet de champ, à grille ultracourte, de type MESFET à structure verticale, comportant supportées par un substrat (18) fortement dopé de type N⁺, une première couche épitaxiale (19) dopée de type N⁺ au niveau de 10¹⁸ at.cm⁻³ environ, une seconde couche épitaxiale active (20) dopée de type N au niveau ≤ 10¹⁵ at.cm⁻³ environ, et une troisième couche épitaxiale (21) dopée de type N⁺ au niveau de 10¹⁸ at.cm⁻³ environ, ainsi que deux contacts électriques de source et de drain, le premier (22) déposé sur la troisième couche (21), le second (23) déposé sur la face libre du substrat (18), et un contact de grille (25), ce transistor étant caractérisé en ce que :

— la seconde couche (20) a une épaisseur inférieure au libre parcours moyen des électrons dans cette couche, constituant une région de grille dont la longueur est sub-micronique,

— la troisième couche (21) et une partie de la deuxième couche (20) — dans son épaisseur — sont en saillie par rapport au substrat,

— une métallisation (25), constituant le contact électrique de grille, d'épaisseur plus faible que celle de la couche active (20) et en contact latéral avec la partie de ladite couche active qui en saillie, s'étend à la surface du substrat, dans lequel sont réalisés des caissons de haute résistivité (24).

2. Transistor à effet de champ selon la revendication 1, caractérisé en ce qu'une métallisation (26) de forte épaisseur, plusieurs milliers d'Å, est déposée sur le contact de grille (25), afin de diminuer la résistance électrique de grille.

3. Transistor à effet de champ selon la revendication 1, caractérisé en ce qu'une couche d'épaisseur de 100 mm environ et dopage de type N au niveau de 10¹⁷ at.cm⁻³ environ, est intercalée entre les première (19) et seconde (20) couches épitaxiales.

4. Transistor à effet de champ selon la revendication 1, caractérisé en ce qu'une couche d'épaisseur de 100 mm environ et dopage de type N au niveau de 10¹⁷ at.cm⁻³ environ, est intercalée entre les seconde (20) et troisième (21) couches épitaxiales.

5. Transistor à effet de champ selon la revendication 1, caractérisé en ce qu'il est réalisé dans un matériau de la famille III.V, du type GaAs.

## Claims

1. Field effect transistor having an having an extremely short gate and of MESFET vertical structure type, comprising, carried on a highly doped substrate (18) of N⁺ type a first epitaxial layer (19) doped of N⁺ type with a doping level of about 10¹⁸ at.cm⁻³, a second epitaxial active layer (20) which is N type doped with a level of about ≤ 10¹⁵ at.cm⁻³, and a third epitaxial layer (21) which is N⁺ type doped with a level of about 10¹⁸ at.cm⁻³, as well as two electrical source and drain contacts, the first (22) being deposited onto the third layer (21) and the second (23) being deposited onto the free face of the substrate (18), and a gate contact (25), this transistor being characterized in that :

— the second layer (20) has a thickness smaller than the mean free path of the electrons within this layer, forming a gate region the length of which is sub-micronic,

— the third layer (21) and a portion of the second layer (20) — in its thickness — are projecting with respect to the substrate,

— a metallization (25) forming the electrical gate contact, having a thickness which is smaller than that of the active layer (20) and which laterally contacts the projecting portion of the active layer, extends on the surface of the substrate within which high resistivity boxes (24) are formed.

2. Field effect transistor according to claim 1, characterized in that a metallization (26) having a high thickness of several thousands of Å is deposited onto the gate contact (25) in order to reduce the electrical resistance of the gate.

3. Field effect transistor according to claim 1, characterized in that a layer of a thickness of about 100 nm and which is N doped with a level of about $10^{17}$ at.cm$^{-3}$ is inserted between the first (19) and second (20) epitaxial layers.

4. Field effect transistor according to claim 1, characterized in that a layer having a thickness of about 100 nm and which N doped with a level of about $10^{17}$ at.cm$^{-3}$ is inserted between the second (20) and third (21) epitaxial layers.

5. Field effect transistor according to claim 1, characterized in that it is formed of a material of the III.V group, of GaAs type.

**Ansprüche**

1. Feldeffekttransistor mit ultrakurzem Gate, vom MESFET-Typ und mit vertikaler Struktur, sowie mit, von einem stark N$^+$-dotierten Substrat (18) getragen, einer ersten epitaktischen Schicht (19), die N$^+$-dotiert ist und mit etwa $10^{18}$ Atomen/cm$^3$ einer zweiten, aktiven epitaktischen Schicht (20), die N-dotiert ist mit etwa $10^{15}$ Atomen/cm$^3$, und einer dritten epitaktischen Schicht (21), die N$^+$-dotiert ist mit etwa $10^{18}$ Atomen/cm$^3$, sowie zwei elektrischen Kontakten für die Source- und Drainelektrode, wovon der erste (22) auf der dritten Schicht (21) und der zweite (23) auf der freien Fläche des Substrats (18) aufgebracht ist, und einem Gatekontakt (25), wobei dieser Transistor dadurch gekennzeichnet ist, daß

— die zweite Schicht (20) eine Dicke aufweist, die geringer ist als die mittlere freie Weglänge der Elektronen in dieser Schicht, so daß ein Gategebiet gebildet ist, dessen Länge geringer als ein Mikron ist,

— die dritte Schicht (21) und ein Teil der zweiten Schicht (20) mit ihrer Dicke in Bezug auf das Substrat vorspringen,

— eine Metallisierung (25), welche den elektrischen Gatekontakt bildet, eine geringere Dicke als die aktive Schicht (20) aufweist und seitlich mit dem vorspringenden Teil der aktiven Schicht in Berührung ist, sich an der Oberfläche des Substrats erstreckt, in dem Kästen (24) mit hohem spezifischen Widerstand gebildet sind.

2. Feldeffekttransistor nach Anspruch 1, dadurch gekennzeichnet, daß eine Metallisierung (26) großer Dicke von mehreren Tausend Å auf dem Gatekontakt (25) aufgebracht ist, um den elektrischen Gatewiderstand zu vermindern.

3. Feldeffekttransistor nach Anspruch 1, dadurch gekennzeichnet, daß eine Schicht einer Dicke von etwa 100 nm und mit einer N-Dotierung von etwa $10^{17}$ Atomen/cm$^3$ zwischen die erste (19) und die zweite (20) epitaktische Schicht eingefügt ist.

4. Feldeffekttransistor nach Anspruch 1, dadurch gekennzeichnet, daß eine Schicht einer Dicke von etwa 100 nm und mit einer N-Dotierung von etwa $10^{17}$ Atomen/cm$^3$ zwischen die zweite (20) und die dritte (21) epitaktische Schicht eingefügt ist.

5. Feldeffekttransistor nach Anspruch 1, dadurch gekennzeichnet, daß er aus einem Material der Gruppe III.V vom GaAs- Typ gebildet ist.

# FIG.1

# FIG.2

# FIG.3

# FIG.4

# FIG.5